Europäisches Patentamt

European Patent Office

Office européen des brevets

Publication number: **0 309 116**

**A2**

## EUROPEAN PATENT APPLICATION

Application number: 88308248.9

Int. Cl.⁴: **H01L 21/68** , **H01L 21/66**

Date of filing: **07.09.88**

Priority: **25.09.87 GB 8722632**

Date of publication of application:
**29.03.89 Bulletin 89/13**

Designated Contracting States:
**AT BE CH DE ES FR GR IT LI LU NL SE**

Applicant: **MARCONI ELECTRONIC DEVICES LIMITED**
**The Grove Warren Lane**
**Stanmore Middlesex HA7 4LY(GB)**

Inventor: **Cooper, Richard Charles**
**c/o 11 Norton Close**
**Cambridge CB5 8NW(GB)**
Inventor: **Pearse, Anthony William**
**72, The Mall**
**Swindon Wiltshire(GB)**

Representative: **Hoste, Colin Francis**
**The General Electric Company p.l.c. Central**
**Patent Department (Wembley Office) Hirst**
**Research Centre East Lane**
**Wembley Middlesex, HA9 7PP(GB)**

Fixture for an integrated circuit chip.

A fixture for a segment of tape, on which an IC chip is mounted, comprises two support members. The tape is held between the support members and is connected to external circuits by way of conductive projections formed in one of the support members. The fixture protects the chip from damage during testing before it is incorporated in a circuit.

*Fig.1.*

EP 0 309 116 A2

# Fixture for an Integrated Circuit Chip

This invention relates to fixtures for integrated circuit chips. In conventional methods of assembling an integrated circuit chip in an electronic circuit. it is common to use a technique known as tape automated bonding. Typically a metal foil is laminated on a length of tape and is then selectively etched to form a series of beam lead frames. The beam leads so formed are subsequently bonded to an integrated circuit chip. Thus. a series of individual tape segments are formed, each segment carrying an integrated circuit chip. Each chip with its respective beam leads is then excised and may be assembled into an electronic circuit.

It is advisable to "burn in" an integrated circuit chip before it is mounted into a complete circuit, as it is difficult to determine at a later stage which of the individual components of a circuit has failed.

One object of this invention is to provide a fixture for an individual tape segment which protects the segment against damage whilst allowing the chips to be tested and submitted to electrical "burn-in".

According to this invention, a fixture for a segment of tape adapted to carry an integrated circuit chip comprises first and second support members between which said segment is held, one of the support members having electrical contacts which bear against respective test pads on said segment and thereby allow electrical connection between the integrated circuit chip and an external circuit.

Preferably the first and second support members have means for mechanically clamping them together so as to locate and hold a tape segment firmly between them. To maintain a uniform pressure throughout the fixture, there may be a cushioning layer (such as a thin section of rubber) between the tape segment and a support member.

The test pads preferably constitute the outer ends of beam leads, the inner ends of said beam leads being connected to the integrated circuit chip.

To maintain the required pressure on the tape, the first and second support members may be held together by a snap-action latch: for example lugs formed on one of said support members may engage with hollows on the other of the said support members. Alternatively the support members may be secured by spigots and clips.

The support members may be substantially rectangular mouldings which are formed from plastics. To connect the contacts formed on one of said members to external circuits, conductive tracks may be formed on the support member extending from the contacts to terminations on at least two of the outer edges of the support member

Preferably the electrical contacts are projections upstanding from the inner surface of the support member. These projections may be formed integrally with the support member.

Conveniently. the conductive tracks pass through holes formed in the support member so that they terminate on the opposite side of the support member to that on which the contacts are formed. However, the tracks may alternatively terminate on the side of the support member on which the contacts are formed.

It is preferable that the contacts be made electrically conductive by means of metallic plating. polymer thick film conductive ink. metal film vacuum deposition or by the use of organometallic materials. Alternatively. conductive plastic may be incorporated into the support member at the contact regions. These techniques may also be used to form the conductive tracking.

Each segment of tape is conveniently formed with a plurality of pairs of sprocket holes. These engage with attachment protrusions formed in one of said support members and serve to hold the segment in position.

A fixture in accordance with the invention will now be described by way of example with reference to Figures 1, 2 and 3 of the accompanying drawings in which:

Figure 1 is a plan view of the first moulding of the fixture,

Figure 2 is a plan view of the second moulding of the fixture showing the integral metallised projections ,

Figure 3 is a sectional view of the assembled top and bottom mouldings of the fixture.

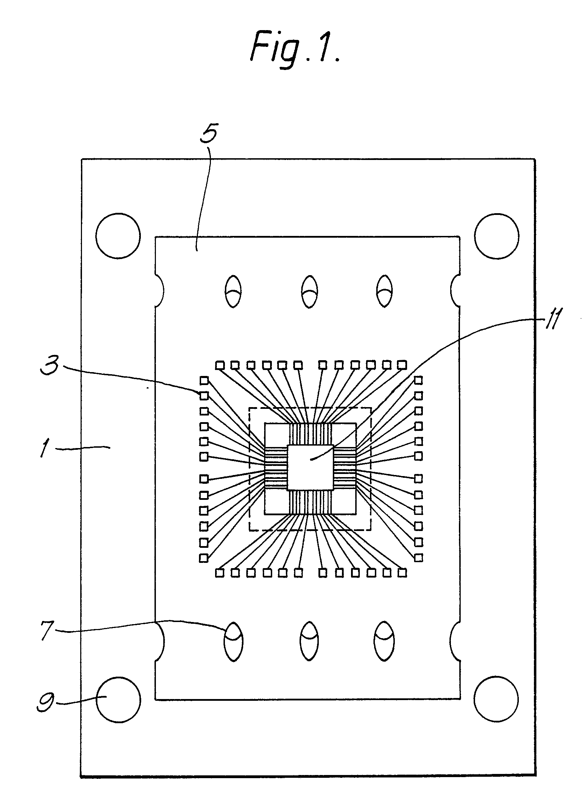

In Figure 1, the first moulding 1 is provided with a plurality of pairs of attachment protrusions 7. each of which fits into one of a corresponding plurality of pair of sprocket holes formed in a segment of tape 5. An integrated circuit chip 11 is bonded to the inner portions of flexible beam leads formed on the segment of tape 5.

The outer portion of each flexible beam lead terminates in a test pad 3 also formed on the segment of tape 5.

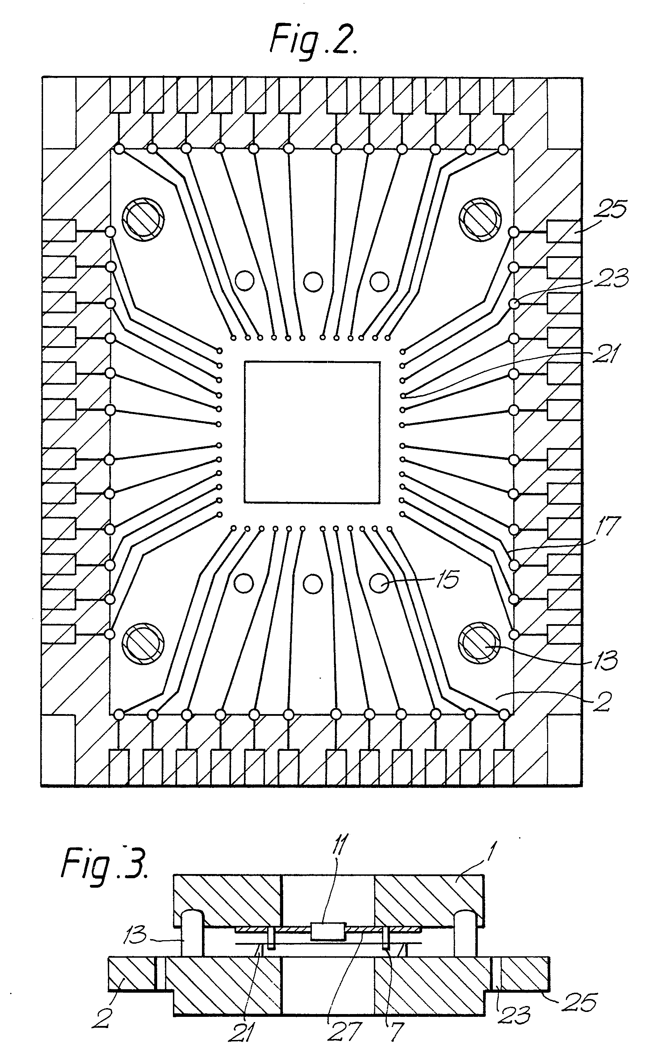

Figure 2 shows the second moulding 2 which fits together with the first moulding by means of snap-action lugs 9 (see Figure 1) which engage with hollows 13 formed in the second moulding 2. The attachment protrusions 7 (see Figure 1) are each accommodated by one of a plurality of recesses 15. Metallised projections 21 are upstanding from the second moulding 2 to make electrical contact with the test pads 3. For connection to an external electrical circuit, a conductive track 17 leads from each projection 21 through a hole 23 and terminates at a conductive pad 25 on the edge of the opposite side of the moulding 2.

In Figure 3, the first and second mouldings 1,2 are shown assembled to hold the tape segment 5 in position. Held together by snap-action lugs 9 engaging with the hollows 13, there is sufficient pressure to ensure that good contact is made between the metallised projections 21 of the second moulding 2 and the test pads 3 formed on the tape segment 5.

A cushioning layer of rubber 27 is positioned between the tape segment 5 and the support member 1 to maintain uniform pressure throughout the fixture.

The integrated circuit chip 11 is held in place and protected by the first and second mouldings during the manufacturing steps between mounting the segment and the removal of the integrated circuit chip 11 preparatory to the chip being mounted on a substrate or in an appropriate package. Because this type of fixture allows the chip to be connected to an external circuit via conductive pads 25, the chip can be tested before mounting. The fixture can also be used to "burn in" the chip before it is assembled into a complete circuit.

Although different designs of tape segment are required to accommodate different integrated circuits, it is possible to design the segments so that the position of the test pads does not alter, allowing the fixture to be used universally.

The second moulding 2 may alternatively be designed so that the conductive pads 25 are formed on the same side of the moulding as the projections 21 so that the moulding 2 need not be formed with through holes 23.

Additionally, the second moulding need only have conductive pads 25 on two of its edges rather than all four as shown in Figure 2.

Once the integrated circuit chip has been tested, the beam leads are excised so that the chip can be removed from the beam lead frame and mounted in a circuit.

## Claims

1. A fixture for a segment of tape adapted to carry an integrated circuit chip comprising first and second support members between which said segment is held, one of the support members having electrical contacts which bear against respective test pads on said segment and thereby allow electrical connection between the integrated circuit chip and an external circuit.

2. A fixture as claimed in Claim 1 wherein said first and second support members have means for clamping them together so as to locate and hold said tape segment firmly between them.

3. A fixture as claimed in Claim 1 or 2 wherein said test pads constitute the outer ends of beam leads, the inner ends of said beam leads being connected to said integrated circuit chip.

4. A fixture as claimed in any preceding claim wherein said first and second support members are held together by a snap-action latch.

5. A fixture as claimed in Claim 4 wherein said snap-action latch comprises lugs formed on one of said support members which engage with hollows on the other of the said support members.

6. A fixture as claimed in any preceding claim wherein said contacts on one of said support members are connected to an external circuit by way of conductive tracks formed on said member which extend from said contacts to terminations on at least two of the outer edges of said member, said member being substantially rectangular.

7. A fixture as claimed in Claim 6 wherein said conductive tracks terminate on the side of the support member on which the contacts are formed.

8. A fixture as claimed in Claim 6 wherein said conductive tracks pass through holes formed in said support member so that they terminate on the opposite side of the support member to that on which the contacts are formed.

9. A fixture as claimed in any preceding claim wherein said electrical contacts are projections upstanding from the inner surface of one of said support members.

10. A fixture as claimed in Claim 9 wherein said projections are formed integrally with the support member.

11. A fixture as claimed in any preceding claim wherein said segment has a plurality of pairs of sprocket holes formed therein, said sprocket holes engaging with attachment protrusions formed in said first moulding such as to hold the segment in position.

12. A fixture as claimed in any preceding claim wherein said electrical contacts are made electrically conductive by means of metallic plating, polymer thick film conductive ink, metal film vacuum deposition or by the use of organometallic materials.

13. A fixture as claimed in Claim 10 wherein conductive plastic is incorporated into the support member to form the contacts and/or the conductive tracking.

14. A fixture as claimed in any preceding claim wherein a cushioning layer is between the tape segment and a support member.

# Fig.1.

## Fig.2.

## Fig.3.